# EUROPEAN PATENT APPLICATION

(11) **EP 1 403 927 A1**
(43) Date of publication of application: **31.03.2004**
(21) Application number: 02425592.9
(22) Date of filing: 30.09.2002
(51) Int. Cl.: H01L 27/105, H01L 21/8247

(54) **High voltage transistor integrated with non-volatile memory cells**

(71) Applicant: STMicroelectronics S.r.l., 20041 Agrate Brianza (Milano) (IT)
(72) Inventor: Zuliani, Paola, 20146 Milano (IT); Giarda, Katia, 28100 Novara (IT); Annunziata, Roberto, 20052 Monza (Milano) (IT)
(74) Representative: Ferreccio, Rinaldo

(57) **Abstract**

A process for fabricating high-voltage drain-extension transistors, whereby the transistors are integrated in a semiconductor substrate (10) along with non-volatile memory cells comprising floating gate transistors, the process comprising at least the following steps:
defining respective active areas (1,2) for HV transistors and floating gate transistors in a common semiconductor substrate (10), with the active areas being separated from each other by insulating regions (3);
depositing a layer (4) of gate oxide onto the active areas;
depositing a layer (5) of polysilicon onto the gate oxide layer (4);
first masking and then etching through the polysilicon layer (5) to form gate regions (7) of the HV transistors;
performing a first dopant implantation to form first portions (9) of the high-voltage transistor junctions;
conformably depositing a dielectric layer (11) onto the whole substrate (10) to provide an interpoly layer of the floating gate transistor;
making openings (12) at the locations of the first portions (9) of the high-voltage transistor junctions;
performing, through the openings (12), a second dopant implantation to form second portions ( 13) of the high-voltage transistor junctions, with the perimetral areas of the gate regions and the active area of the floating gate transistor being screened off by the dielectric layer (11).

## Description

### Field of Application

The present invention relates to a process for fabricating a high-voltage transistor integrated in a semiconductor substrate in association with non-volatile memory cells.

Specifically, the invention relates to a process for fabricating high-voltage (HV) drain-extension transistors integrated on a semiconductor substrate along with non-volatile memory cells comprising floating gate transistors, the process comprising at least the following steps:
- defining respective active areas for HV transistors and floating gate transistors in a common semiconductor substrate, with said active areas being separated from each other by insulating regions;
- depositing a layer of gate oxide onto said active areas;
- depositing a layer of polysilicon onto the gate oxide layer;
- first masking and then etching through the polysilicon layer to form gate regions of said HV transistors;
- performing a first dopant implantation to form first portions of the high-voltage transistor junctions;
- conformably depositing a dielectric layer onto the whole substrate to provide an interpoly layer of said floating gate transistor.

The invention further relates to a high-voltage transistor, being integrated in a semiconductor substrate with a first type of conductivity and comprising a gate region comprised between corresponding drain and source junctions, of the type in which said junctions comprise lightly doped first regions with a second type of conductivity and more heavily doped second regions with the second type of conductivity.

Although not limited to, the invention relates to a process for fabricating a high-voltage transistor, being integrated in a semiconductor substrate along with a non-volatile memory cell, and the following description will cover this field of application for convenience of illustration only.

### Prior Art

As it is well known in this technical field, a more frequent market trend regards the demand of low-consumption and high-density logic circuits to be integrated as well as non-volatile memories, within a common semiconductor electronic device. This necessity greatly complicates the process of fabricating such integrated electronic devices because, as explained hereinafter, either circuit types are fabricated with technologies that are not fully compatible with each other. This reflects on increased manufacturing costs as well as increased difficulty to achieve high performance levels.

For example, fabricating suitable HV (High-Voltage) transistors to handle high voltages (>12V) used in programming non-volatile memory cells is a complicated process that is not compatible with the concurrent presence of low-voltage logic circuits (microcontrollers, SRAMs, ROMs).

Another matter of concern is the speed rate of transmission of electric signals normally expected to be reached by such devices. On this account, the transistors incorporated in such devices are conventionally subjected to a silicidation treatment. This treatment basically consists of metallizing the junctions and gate regions of logic circuit transistors with silicide, and has a drawback in that it reduces the breakdown performance of the junctions.

This runs counter to the necessity to form HV transistors, which have a characterizing feature in their high resistance to breakdown.

A first prior approach to raising the value of a transistor breakdown voltage has consisted of changing the dopant levels of the source and drain junctions.

In particular HV transistors, whose breakdown voltage is provided sufficiently high to handle high bias and operating voltages, have had their source and drain junctions formed from lightly doped regions.

Although advantageous under many points of view, this prior approach has a number of drawbacks. In particular, a compromise between an admissible breakdown voltage and the active characteristics of the transistor as regards current delivery must be reached. The high serial resistance that a lightly doped junction is bound to introduce adds to the difficulty of finding an effective working point between the breakdown voltage and the transistor saturation current.

Another problem of high-voltage transistors is the high intensity of the electric fields established between the borderline of the active area and the field oxide of the transistor.

The underlying technical problem of this invention is to provide a process for fabricating a high-voltage transistor, which has structural features such to prevent the occurrence of high electric fields in the silicon, specifically at the borderline area between the field oxide and the active area of the transistor where the source and drain junctions are located, thereby overcoming the drawbacks of prior processes to integrate electronic devices with different electrical requirements in a common substrate.

### Summary of the Invention

The solution idea on which this invention stands is the one of providing a process for fabricating a memory cell and a high-voltage transistor comprising a dual source/drain junction, which process has steps in common with the process used for fabricating non-volatile memory cells.

Based on this idea, the technical problem is solved by a process as indicated above, and as defined by the characterizing part of Claim 1.

The problem is further solved by a transistor as indicated above, and as defined by the characterizing part of Claim 5.

The features and advantages of the process according to the invention should become understood from the following description of an embodiment thereof, given by way of non-limitative example with reference to the accompanying drawings.

### Brief Description of the Drawings

In the drawings:
- Figures 1 to 4 show an enlarged cross-sectional schematic view of a portion of a semiconductor integrated circuit, comprising a non-volatile memory cell and a high-voltage transistor, during the several steps of its fabricating process;
- Figures 5 and 6 show schematic top view of the high-voltage transistor portion of the circuit shown in Figure 2 and 4, respectively; and
- Figure 7 shows a schematic enlarged cross-sectional view of the high-voltage transistor of this invention.

### Detailed Description

The process steps and the structures described herein below do not purport to be exhaustive of a process flow for fabricating integrated circuits.

This invention can be practised in combination with IC fabrication techniques currently in use, and only such conventional process steps which are necessary to an understanding of this invention will be described.

Drawings that show cross-sections through portions of an integrated circuit at different stages of its fabrication process are not true to scale, being rather directed to highlight major features of the invention.

A process for fabricating a high-voltage transistor in association with a non-volatile memory cell, according to this invention, will now be described with reference to the drawing views.

First, the active areas of the different transistors are defined on a semiconductor substrate 10.

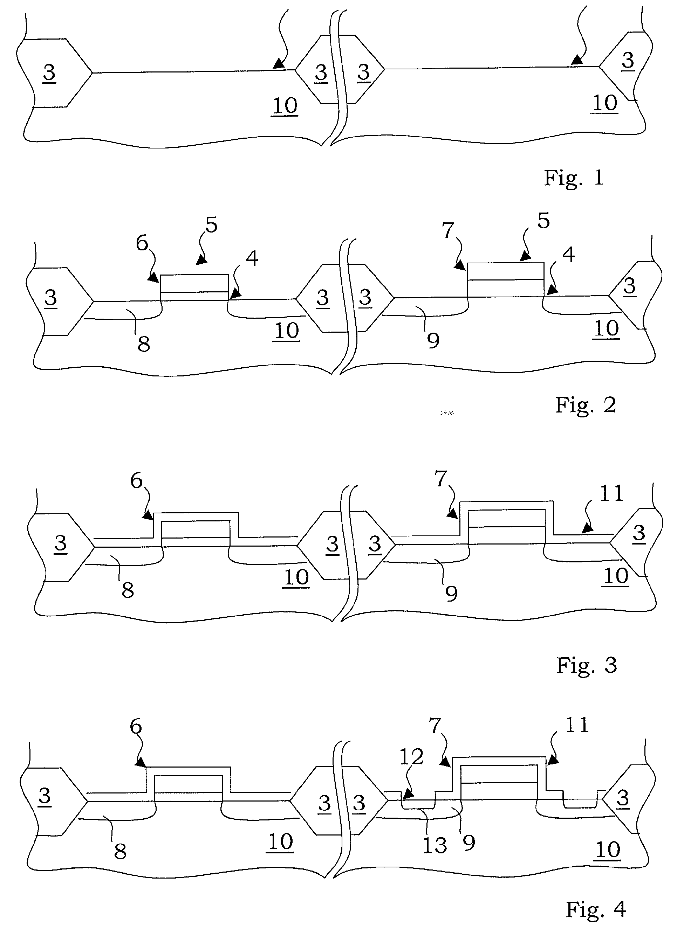

As shown in Figure 1 by way of example, an active area 1 for a memory cell comprising a floating gate transistor and an active area 2 for a HV transistor are defined.

These active areas are separated from each other, as well as from all the other devices in the semiconductor 10, by an insulating field oxide region 3.

Of course, every active area are realised for a predetermined type of transistors.

A thin layer 4 of gate oxide is formed on top of the active areas 1 and 2. The thickness of the layer 4 may be greater over the active area 2 for the HV transistor, as shown in Figure 2 for example. Also, the portion of the layer 4 that overlies the active area 1 of the floating gate transistor may vary in thickness to suit the type of non-volatile memory cell to be fabricated.

The above is followed by a step of depositing a polysilicon layer 5, for forming the gate regions of both the HV and the floating gate transistors.

A first poly mask is used for defining and forming the gate region 7 of the high-voltage transistor and the floating gate region 6 of the floating gate transistor, where the process is arranged to include this step. A polysilicon layer 5 is etched away from either sides of the gate region, as shown in Figure 2.

Light dopant is then implanted to form first portions 9 of the high-voltage transistor junctions.

Another dopant implanting step is carried out to form source and drain junctions of the floating gate transistor, where the process is arranged to include this step.

According to the invention, the first light dopant implanting step is followed by a step of depositing a conformable dielectric layer 11 onto the entire semiconductor 10.

The dielectric layer 11 is formed by means of an ONO (Oxide-Nitride-Oxide) layer.

This dielectric layer 11 is used, in a conventional process flow for fabricating non-volatile memory cells, to provide the interpoly dielectric layer of the non-volatile memory cell.

Advantageously, this dielectric layer 11 would be a thin layer that has been conformably deposited.

Openings 12 are made in such a dielectric layer 11 aligned to the first portions 9 of the high-voltage transistor junctions.

The widths of the openings 12 and their locations relative to the first portions 9 of the high-voltage transistor are selected such that the thick oxide layer 3, marking the borderline of the active area of the high-voltage transistor, and the perimetral area of the gate region of the high-voltage transistor are covered with the dielectric layer 11.

A heavy dopant implantation is then applied through the openings 12, in order to form second portions 13 of the high-voltage transistor.

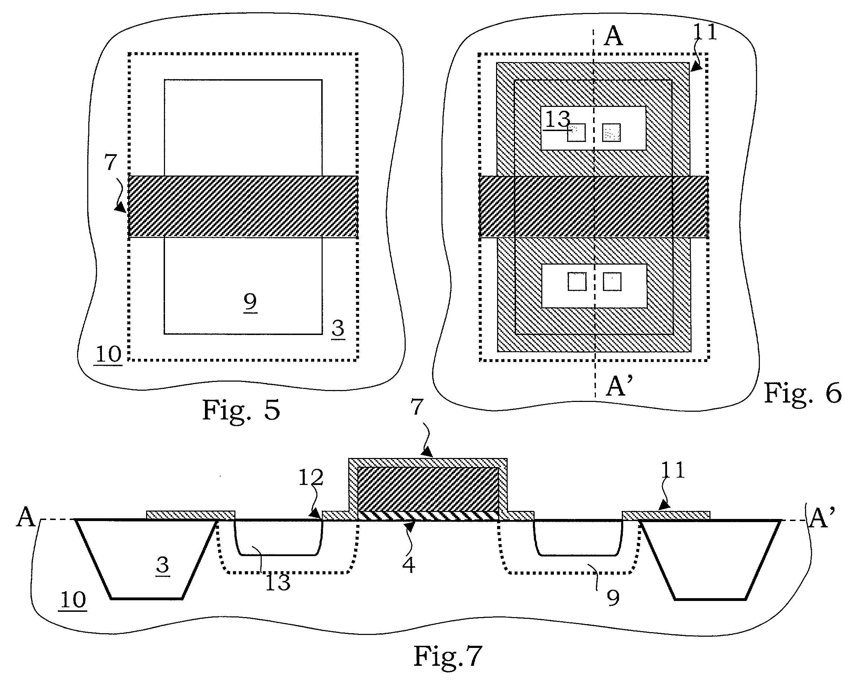

Advantageously, the second portions 13 of the high-voltage transistor are entirely included within the first portions 9 of the high-voltage transistor, as shown in detail in Figures 4 and 7. This embodiment allows a high-voltage transistor to be formed having a high breakdown voltage, yet prevents strong electric fields from occurring in the semiconductor substrate at the borderline between the field oxide and the active area of the transistor.

Advantageously, the dielectric layer 11 is selectively removed in order to make the openings 12 using a pattern on a mask, known as the matrix mask, employed in the conventional fabrication process of non-volatile memory cells. In particular, the same mask is used as in removing the dielectric layer 11 from those portions of the substrate 10 where low-voltage devices, such as low-voltage transistors, are to be formed.

Advantageously, the process of this invention allows the same heavy implantation to be used for forming the junctions of both the low- and the high-voltage transistors. As the size of the single devices decreases, the low-voltage transistor junctions are formed with surface junctions. Briefly, the process of the invention meets the requirements for simultaneously fabricate high- and low-voltage devices associated with non-volatile memory cells.

Furthermore, by calibrating the distances of the openings 12 from the gate region of the high-voltage transistor, and from the perimeter of the active region, the second portions 13 can be located within the first portions 9, thereby achieving the intended transistor performance.

The process phases of the invention then include a conventional step of siliciding the junctions not covered by dielectric layers.

The process of the invention is completed with conventional steps, not illustrated, aimed at providing a finished memory device.

The process of this invention allows drain-extension HV transistors to be integrated along with non-volatile memory cells by a simple modification to the interpoly layer patterning step in a process flow for fabricating non-volatile memory cells.

In addition, the inventive process has the advantage of allowing the fabrication of drain-extension HV transistors to include a step of siliciding the junctions of high-voltage transistors in a consistent manner with advanced logics. The process, moreover, involves no additional contact implantations.

It should be further noted that the dopant profile of the gate regions of the high-voltage transistors can be set, in the process of the invention, so that the junction breakdown in the high-voltage transistor is adequately high.

To summarize, the process of this invention allows high-voltage transistors to be produced which have first portions 9 of the source and drain junctions that are lightly doped formed close to the gate regions and the field oxide layers, and second portions 13 of the source and drain junctions that are more heavily doped locally in order to be compatible with a silicide layer (TiSi2/ CoSi2) being formed at no risk of harming the junction by dopant depletion.

In particular, the dielectric layer 11 is used to screen the regions realised close to the gate region and the field oxide layer at the edge of the active area with respect to the heavy second implantation in the high-voltage device.

This process has been described in connection with one possible process flow for fabricating non-volatile memory cells. However, from the process of this invention can also benefit processes for fabricating non-volatile memory cells of the self-aligned type. Specifically in such self-aligned processes, the etching step for the gate region of the floating gate transistor would be carried out after forming the high-voltage transistor according to the invention.

## Claims

1. A process for fabricating high-voltage drain-extension transistors, whereby the transistors are integrated in a semiconductor substrate (10) along with non-volatile memory cells comprising floating gate transistors, said process comprising at least the following steps:
- defining respective active areas (1,2) for HV transistors and floating gate transistors in a common semiconductor substrate (10), with said active areas being separated from each other by insulating regions (3);
- depositing a layer (4) of gate oxide onto said active areas;
- depositing a layer (5) of polysilicon onto the gate oxide layer (4);
- first masking and then etching through the polysilicon layer (5) to form gate regions (7) of said HV transistors;
- performing a first dopant implantation to form first portions (9) of the high-voltage transistor junctions;
- conformably depositing a dielectric layer (11) onto the whole substrate (10) to provide an interpoly layer of said floating gate transistor; **characterized in that** openings (12) are made at the locations of said first portions (9) of the high-voltage transistor junctions;
- performing, through said openings (12), a second dopant implantation to form second portions (13) of the high-voltage transistor junctions, with the perimetral areas of the gate regions and the active area of the floating gate transistor being screened off by said dielectric layer (11).

2. A process according to Claim 1, **characterized in that** said second portions (13) of the floating gate transistor junctions are shallower than said first portions (9) of the floating gate transistor junctions.

3. A process according to Claim 1, **characterized in that** it comprises a step of siliciding said second portions (13) of the high-voltage transistor junctions.

4. A high-voltage transistor, being integrated in a semiconductor substrate (10) with a first type of conductivity and comprising a gate region (7) comprised between corresponding drain and source junctions, wherein said junctions comprise first regions (9) lightly doped with a second type of conductivity and heavily doped second regions (13) with the second type of conductivity, **characterized in that** said more doped second regions (13) lie within said lightly doped first regions (9), and that said drain and source junctions are covered by a thin dielectric layer (11) only at the locations of said lightly doped first regions (9).
